(19) Europäisches Patentamt / European Patent Office / Office européen des brevets

(11) EP 2 741 092 B1

(12) EUROPEAN PATENT SPECIFICATION

(45) Date of publication and mention of the grant of the patent:
02.05.2018 Bulletin 2018/18

(51) Int Cl.:
$G01R\ 19/25^{(2006.01)}$ $G01R\ 23/02^{(2006.01)}$

(21) Application number: 12306558.3

(22) Date of filing: 10.12.2012

(54) **Estimating an electricity supply's fundamental frequency**

Schätzen der Grundfrequenz einer Stromversorgung

Estimation de la fréquence fondamentale d'une alimentation électrique

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(43) Date of publication of application:
11.06.2014 Bulletin 2014/24

(73) Proprietor: Itron Global SARL
Liberty Lake WA 99019 (US)

(72) Inventors:
• CHANEDEAU, Gwladys Fabienne Alice
F-86170 Blaslay (FR)
• GAUBERT, Jean-Paul
F-86000 Poitiers (FR)
• TISSIER, Jean-Francois
F-86360 Chasseneuil du Poitou (FR)

(74) Representative: Shipp, Nicholas
Kilburn & Strode LLP
Lacon London
84 Theobalds Road
London WC1X 8NL (GB)

(56) References cited:
WO-A2-2008/055499    US-A1- 2005 207 190
US-A1- 2009 105 979    US-A1- 2012 150 468

• YANG HAN ET AL: "A novel synchronization scheme for grid-connected converters by using adaptive linear optimal filter based PLL (ALOF-PLL)", SIMULATION MODELLING PRACTICE AND THEORY, vol. 17, no. 7, 2009, pages 1299-1345, XP055062959, ISSN: 1569-190X, DOI: 10.1016/j.simpat.2009.05.004
• FELICE LICCARDO ET AL: "Robust and Fast Three-Phase PLL Tracking System", IEEE TRANSACTIONS ON INDUSTRIAL ELECTRONICS, IEEE SERVICE CENTER, PISCATAWAY, NJ, USA, vol. 58, no. 1, 2011, pages 221-231, XP011338450, ISSN: 0278-0046, DOI: 10.1109/TIE.2010.2044735
• BOUAFIA A ET AL: "Design and implementation of predictive current control of three-phase PWM rectifier using space-vector modulation (SVM)", ENERGY CONVERSION AND MANAGEMENT, ELSEVIER SCIENCE PUBLISHERS, OXFORD, GB, vol. 51, no. 12, 2010, pages 2473-2481, XP027180900, ISSN: 0196-8904 [retrieved on 2010-06-09]

EP 2 741 092 B1

**Description**

**Field of Invention**

The present disclosure relates to frequency estimation of an electrical signal. More specifically, but not exclusively, the present disclosure provides a means for estimating a frequency at a point within an electricity grid network.

**Background to the Invention**

Stability of electricity grids is extremely important in the developed world where so much of everyday life relies upon an electricity supply. If electricity supplied by electricity grid is unstable then there is high risk of a blackout occurring, which in some circumstances can result in large areas of a country, or even continent, losing power for relatively long periods of time. While blackouts are a general annoyance to everyone in a blackout zone, they also have an economic effect on businesses in the blackout zone and beyond.

US2005207190A discloses a power system having a phase locked loop (PLL) with a notch filter for synchronous reference frame sequence separation. The notch filter includes a generalized integrator tuned to the notch frequency. The output of the generalized integrator is summed with the filter input signal and the output of the summer is fed back to the integrator input. In one embodiment, the notch filter is programmable by a control signal generated in response to the filter output signal, thereby causing the filter to self-regulate to a frequency related to the PLL input signal.

YANG HAN ET AL: "A novel synchronization scheme for grid-connected converters by using adaptive linear optimal filter based PLL (ALOF-PLL)", XP055062959, Simulation Modelling Practice and Theory, volume 17 (2009) pages 1299-1345, is a paper that proposes a novel grid synchronization scheme using a new phase-locked loop (PLL) scheme based on the adaptive linear optimal filtering (ALOF) technique.

In order to help prevent blackouts occurring it is necessary to precisely monitor the frequency of electricity being supplied by an electricity grid in order to detect unusual fluctuations in the electricity supply. Since abnormal excursions of the fundamental frequency of the electricity supply and the rate of change of the electricity supply outside of the normal limits usually occur just before a blackout, not only the accuracy of the frequency analysis, but the speed of the frequency analysis is of utmost importance. The frequency analysis is carried out by frequency protection relays installed in medium voltage (MV) or high voltage (HV) substations so that if a problem is detected the power can be cut off at those substations and thereby prevent damage to devices supplied via that substation.

While these protection relays operate relatively quickly, usually in less than 5 seconds of the frequency drifting out of normal operating conditions, this unfortunately results in large areas of the network being cut off. Furthermore, the classical methods to estimate the fundamental frequency and the rate of change of frequency of an electrical signal are complex and therefore computationally expensive.

With the future of electricity supply looking to become more reliant on smart grids with electricity being supplied from a large range of sources with differing power levels, the problem of managing electricity supply throughout a network will be more challenging. New ranges of smart meters may help with such problems because the smart meters themselves include a disconnecting switch in series with the supply to and from the grid. Consequently, network control can be provided throughout the grid from a remote central controller. However, when time for delivery of network communications also has to be taken into account, in addition to the processing resources available on smart meters, it is important that the speed at which an accurate frequency estimate is obtained is increased.

**Summary of Invention**

Embodiments of the present invention attempt to mitigate at least some of the above-mentioned problems.

In accordance with an aspect of the invention there is provided a method for estimating a frequency of an electrical signal. The method comprises converting a first signal having three components into a second signal having two components in accordance with a first transformation. Each component of the first signal corresponds to a phase component of a three-phase electrical signal and the two components of the second signal are representative of characteristics of the three-phase electrical signal. The method further comprises filtering the second signal in accordance with a previous frequency estimation. The method also comprises converting the filtered second signal into a third signal having a single component in accordance with a second transformation. The single component of the third signal is representative of characteristics of the three-phase electrical signal. The method further comprises estimating a frequency of the third signal. The estimated frequency of the third signal is indicative of a frequency of the three-phase electrical signal.

The filtering may comprise applying a band pass filter to the second signal, the band pass filter being centred on the frequency of a previous frequency estimation. The band pass filter may be arranged to apply unity gain and zero phase shift at the frequency of the previous frequency estimation.

The method may further comprise feeding back the current frequency estimation for filtering the next frequency estimation.

The first transformation may be a Concordia transformation. The Concordia transformation may be defined by:

$$\begin{bmatrix} V_\alpha \\ V_\beta \end{bmatrix} = \sqrt{\frac{2}{3}} \begin{bmatrix} 1 & -\frac{1}{2} & -\frac{1}{2} \\ 0 & \frac{\sqrt{3}}{2} & -\frac{\sqrt{3}}{2} \end{bmatrix} \begin{bmatrix} V_a \\ V_b \\ V_c \end{bmatrix}$$

wherein $V_a$, $V_b$, $V_c$ are the three components of the first signal and $V_\alpha$ and $V_\beta$ are the two components of the second signal.

The second transformation may utilise a previous estimation of a phase of the three-phase electrical signal.

The second transformation may be a Park transformation. The Park transformation may be defined by:

$$\begin{bmatrix} V_d \\ V_q \end{bmatrix} = \begin{bmatrix} \cos(\hat{\theta}) & \sin(\hat{\theta}) \\ -\sin(\hat{\theta}) & \cos(\hat{\theta}) \end{bmatrix} \begin{bmatrix} V_\alpha \\ V_\beta \end{bmatrix}$$

wherein $V_\alpha$ and $V_\beta$ are the two components of the second signal after being filtered, $\hat{\theta}$ is a previous estimation of a phase of the three-phase electrical signal, and $V_d$ and $V_q$ are outputs of the second transformation, wherein $V_d$ is forced to zero and $V_q$ therefore corresponds to the third signal.

The frequency may be estimated by estimating a phase of the third signal and estimating the frequency of the third signal in accordance with the estimated phase.

The phase may be estimated using a phase locked loop. The phase locked loop may comprise a loop filter arranged to estimate an angular frequency of the signal having a single component and a voltage controlled oscillator arranged to estimate the phase of the estimated angular frequency.

The method may further comprise feeding back the estimated phase to the second transformation for estimating a next phase.

The method also further comprise calculating the average frequency over a period of time. A plurality of frequency estimations may be made during the period of time.

The method may further comprise determining an error level in the frequency estimation and excluding any frequency estimations from the average frequency calculation having an error level greater than an error threshold.

The method may further comprise determining a rate of change of frequency from the average frequency.

The method may also further comprise measuring the three components of the three-phase electrical signal. The measurement may comprise measuring voltages of the three-phase electrical signal.

The method may further comprise converting a single-phase electrical signal into the three-phase electrical signal in accordance with a third transformation before converting the three-phase signal in accordance with the first transformation.

In accordance with a further aspect of the invention there is provided apparatus for estimating a frequency of an electrical signal, the apparatus arranged to implement any method as described herein.

The apparatus may be an electricity meter. The electricity meter may further comprise a sensor arranged to measure one or more characteristics of an electrical signal, a memory arranged to store the one or more characteristics of the electrical signal and store a computer program for implementing the method, a processor arranged to perform the method in accordance with the stored characteristics of the electrical signal and the computer program, and a communications unit arranged to transmit information relating to the frequency estimation to a central server.

In accordance with yet another aspect of the invention there is provided a computer readable medium comprising computer readable code operable, in use, to instruct a computer to perform any of the methods described herein. Embodiments of the invention provide a robust algorithm calculating the main frequency, the average value of the fundamental frequency and the rate of change of the fundamental frequency per cycle using samples of the electrical grid voltages or currents of an electricity meter. The algorithm may be embedded inside the metrology firmware of an electricity meter. The algorithm may take into account the technical capabilities of smart meters for improved performance.

Algorithms provided in accordance with embodiments of the invention are compatible with the sampling rate in the kHz range used by electricity meters. In addition, such algorithms are operational for single phase or poly phase electricity supplies.

Embodiments of the invention improve the accuracy of estimating the fundamental frequency of an electrical signal and the insensitivity of such a signal to perturbations of waveforms, such as harmonics in an unbalanced three phase system. For example, a constant change of 2 millihertz per cycle of a 50Hz waveform may produce a rate of change of 0,1 Hz per second.

Embodiments of the invention provide frequency estimation with accuracy better than +/-1 millihertz.

Embodiments of the invention estimate the fundamental frequency at the sampling frequency of the electricity meter and determine the rate of change of the fundamental frequency on each cycle of the main frequency. These parameters may be determined within a smart meter.

Embodiments of the invention provide a smart meter associated with a switch in series with the power supply arranged to disconnect the load connected to the smart meter from the power supply when conditions of instability of the fundamental frequency are detected. The instability may be detected by the smart meter. The instability may be detected by a remote device, which remotely controls the disconnection of the load connected to the smart meter. The conditions for disconnecting the load directly at the smart meter may be the accuracy, the reliability and/or the speed of the detection of the fundamental frequency and/or the rate of change of the fundamental frequency. The system may be arranged so that the disconnection takes place at the smart meter if and only if the disconnection at the smart meter is faster, more accurate and robust in stabilizing the frequency than performing a disconnection at the MV substation. It will be appreciated that in some embodiments the switch is incorporated within the smart meter, while in alternative embodiments the switch may be separate from the meter and controlled by the smart meter.

Advantageously, embodiments of the invention may perform preventive shedding quick enough to avoid a bulk regional blackout from HV / MV substations.

In embodiments of the invention, a decision regarding a disconnection at a meter may be a local decision taken prior to transmission of data to a central server for a global decision to be made.

Conveniently, an algorithm for controlling the operation of a smart meter as disclosed herein may be embedded in the firmware of an electricity meter.

In embodiments of the invention, data samples of a voltage and/or a current of the electricity meter may be used as inputs for estimation of the fundamental frequency. In a polyphase system, the three phase voltages or the three phase currents may be utilized.

Embodiments of the invention estimate the fundamental frequency with high accuracy (e.g. +/-1milliHertz). The sampling frequency is the sampling frequency of the metrology firmware. The rate of change of the fundamental frequency may be evaluated per fundamental cycle. A couple of estimated quantities, such a frequency and rate of change of frequency may be constituted per cycle. This couple of results may be used for detecting of network frequency instability as an embedded function of detection of pre-blackout conditions that is an abnormal excursion of the couple of parameters, frequency and rate of change of frequency, outside of a boundary.

Embodiments of the invention use a phase locked loop (PLL) to estimate the phase and/or frequency. The PLL may provide feedback control of the phase angle relative to a reference angle. The PLL may include one or more of a phase detector, a loop filter, a controlled oscillator and a single or three phases signal input. The input may be a current or three phases currents. The input is preferably a voltage. Or a three phases voltage.

Embodiments of the invention use a Concordia transformation to transform a three-phase signal into two parts. Embodiments of the invention use a Park transformation to transform a two part signal into a single part signal.

Advantageously, embodiments of the invention use a PLL which is capable of behaving correctly for purely sinusoidal signals and input signals having strongly deformed harmonics or transients. Consequently, embodiments of the invention reduce unwanted oscillations that may occur due to deformed harmonics and/or input signals. Embodiments of the invention are therefore capable of accurately estimating the fundamental frequency and rate of change of the fundamental frequency when such input conditions are present on the electrical grid waveforms.

Embodiments of the invention provide a phase locked loop (PLL) scheme which is the cooperation inside a closed loop at the sampling rate of a PLL and two adaptive modules. The first adaptive module may be an adaptive multi variable band pass filter. The adaptation of the parameters of the band pass filter may be performed in real time in the loop by reinjection of the estimated frequency inside the band pass filter transfer function. This highly selective filter has the advantage of maintaining the amplitude of the processed signal without introducing any phase shift of the instantaneous frequency, which is updated at each sample. The second adaptive module may be the injection of the estimated phase angle inside the regulation loop.

Embodiments of the invention use adaptive filters and transformations that are recalculated at each sample, which assures the robustness and accuracy of the fundamental frequency tracking.

Embodiments of the invention provide an algorithm that can be implemented in a smart meter on the basis of a sampled signal of single- or poly-phase electrical signal at a relatively low rate (e.g. in the kHz range) allowing an accurate and robust estimate of the fundamental frequency of the electrical grid and the rate of change of the fundamental frequency per cycle. The algorithm may also be designed for a single phase or poly-phase input signal, offering the same accuracy for frequency estimation at the sampling frequency of the metrology and its rate of change of the fundamental frequency at each cycle.

Embodiments of the invention also allow for different types of treatment of the calculated data inside the meter. For example, some embodiments of the invention register the maximum and minimum values of frequency and of the frequency derivative. Furthermore, some embodiments of the invention present frequency as a function of the time, the derivative of the frequency as a function of the time, as well as frequency and its derivative as 2D or 3D graphics.

Advantageously, less memory needs to be transmitted to a central server. The central server can therefore have a reduced memory size. This is because the fundamental frequency can be calculated at the sampling frequency and the rate of change of the fundamental frequency may be determined per cycle. These two values are usually inside normal limits. Consequently, the meter need not store these values in its memory. In reality only a limited volume of data may be stored in the meter and can be transmitted to the central server. For example, only the extreme values (e.g. $f_{min}$ or $f_{max}$ or $\frac{df}{dt}min$ or $\frac{df}{dt}max$) per day need be stored.

Since the algorithm provided in accordance with embodiments of the invention can utilize the hardware of known electricity meters the present invention advantageously provides limited increase in the cost of an electricity meter.

Embodiments relate to a metrology firmware of an electricity meter which can work both on a time axis and on a frequency axis. This combination of a metrological firmware working at the sampling frequency of the meter on these two axes is an advantageous feature of such embodiments.

When working in the time domain, static electricity meters according to embodiments of the invention use sampled values of V (t) (single-phase or three-phase voltages) and I(t) (phase currents(s)). The sampling frequency Fs is a constant frequency. The cumulative products of Vi(nTs).Ii(nTs) by Ts (the sampling period) determines the active power: dPactive = Vi. Ii.Ts. The 50/60Hz reactive power is then obtained in the same manner via a rotation of 90 ° of the current waveform (a numerical filter provides this phase rotation at 50/60Hz). The time domain is also used to determine the periods for calculating rms values of voltage and current (2 cycles to 1second) and apparent power and energy Vrms.Irms.

When working in the frequency domain, the principle of embodiments of the invention is to provide a very precise sample of the fundamental frequency (e.g. +/-1mHz provides a relative accuracy of +/-0.002%). A software sensor obtains a signal representative of the AC network from sampled data of the voltage waveform(s). Consequently, a metrology computing with sampled values of V (t) and I (t) and an estimated value of f (t) is obtained.

The principle of such embodiments of the invention opens the way for accurate monitoring of the fundamental frequency and its stability with software implemented in the electricity meter, but also opens the way to all digital calculations like Discrete Fourier Transform (DFT). For example, extraction of amplitudes and phases of the fundamental and harmonics of all measured waveforms is possible. These calculations can be done directly from the signal, alternatively these windows can be discontinuous, or the calculations can also be done using a sliding window having a minimum length equal to one cycle of a fundamental cycle.

A real-time and highly accurate estimation of the fundamental frequency opens the way for the analysis of harmonic rank powers (active, reactive, apparent). The harmonic powers can be estimated precisely at a metering point and then correlated between different metering points connected to the same utility electrical grid to achieve the goal of quantifying the responsibility of each site in the global harmonic pollution of the grid.

## Brief Description of the Drawings

Exemplary embodiments of the invention shall now be described with reference to the drawings in which:

Figure 1 illustrates an electricity grid according to an embodiment of the invention;
Figure 2 illustrates a smart meter for use in the electricity grid of Figure 1;
Figure 3 provides a schematic illustration of an algorithm for estimating the fundamental frequency and rate of change of the fundamental frequency of an electrical signal at the smart meter of Figure 2;
Figure 4 illustrates the rate of change of frequency, as a function of frequency, for the excursion of the fundamental frequency for the well-known major European grid disturbance on 4 November 2006;
Figure 5 provides a three dimensional graphical representation of the disturbance shown by Figure 4 in terms of the rate of change of frequency, as a function of frequency, and time;
Figure 6 illustrates the variation of frequency over time for the disturbance shown in Figures 4 and 5 as computed with the algorithm of Figure 3;
Figure 7 illustrates the variation of frequency over time for the disturbance shown in Figures 4 and 5 as measured in the field; and
Figure 8 illustrates the error between the estimated frequency measurements shown in Figure 6 with respect to the field measurements shown in Figure 7.

Throughout the description and the drawings, like reference numerals refer to like parts.

**Specific Description**

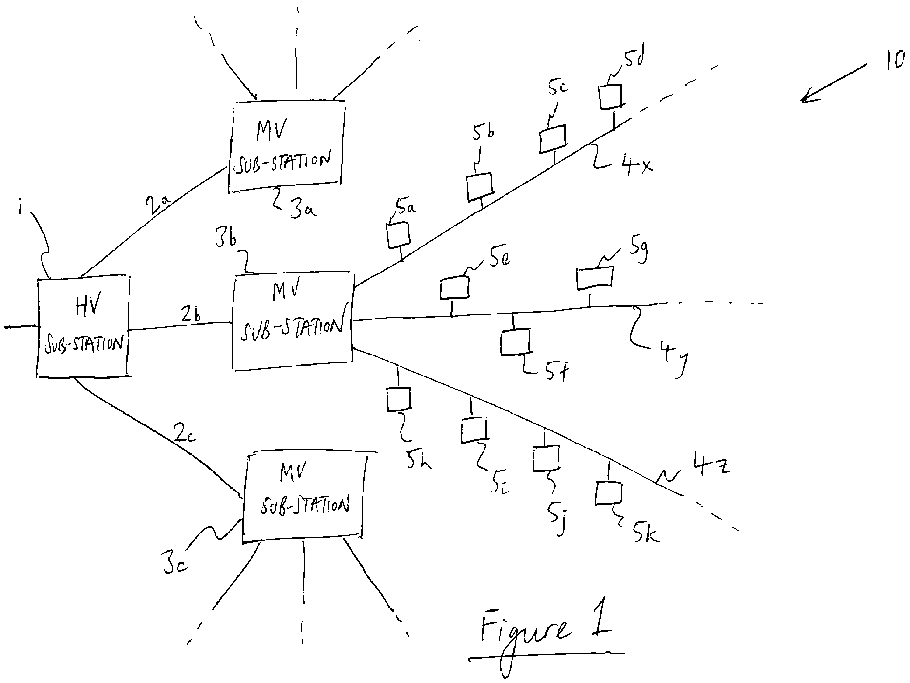

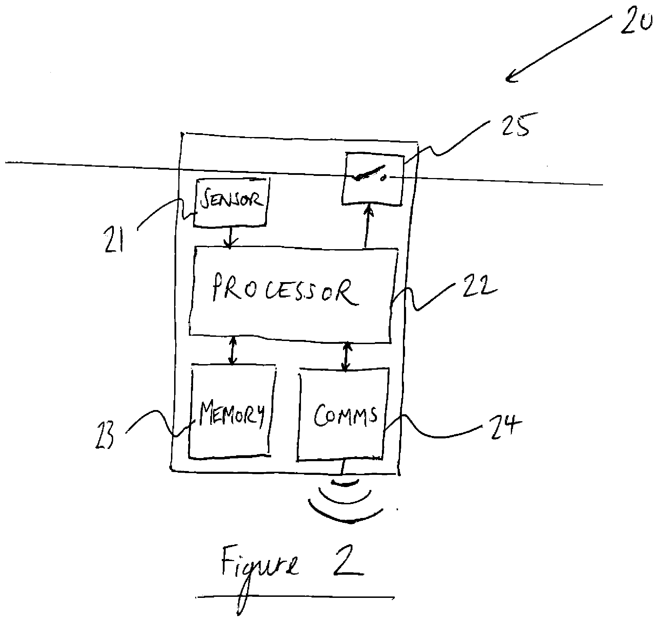

Figure 1 illustrates an electricity grid 10 according to an embodiment of the invention. A power supply generated at a power station (not shown) is received at a high voltage (HV) substation 1 where the voltage is stepped down for further distribution. The reduced voltage power is then transmitted via connections 2a, 2b and 2c to medium voltage (MV) substations 3a, 3b and 3c where the voltage is then stepped down further for local distribution. Each of the MV substations then supplies electricity to a number of distribution lines each having a number of loads connected. For example, MV substation 3b supplies three supply lines 4x, 4y, 4z each having a number of loads 5a-5k connected thereto. One or more of the loads 5a-5k have a smart meter (not shown) connected between the supply line 4x, 4y, 4z and the respective load 5a-5k. One such smart meter is shown in Figure 2, which is discussed in more detail below.

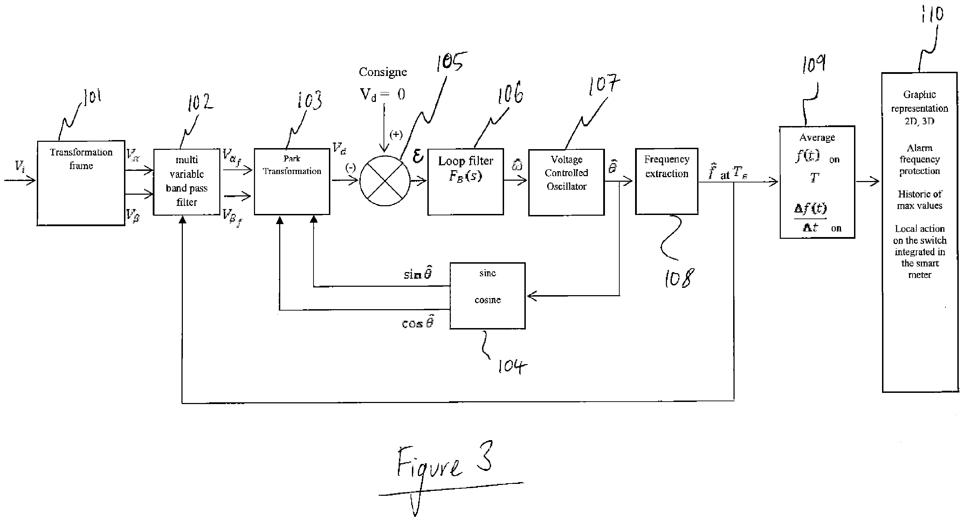

Figure 2 illustrates smart meter 20 for use in the electricity grid 10. The smart meter 20 is arranged to monitor the electricity being drawn by a load to which it is connected via a sensor 21 and a processor 22. The sensor 21 measures either a current and/or a voltage of the electricity supply. Preferably, the smart meter has a current sensor and voltage sensor between each phase supply along with a reference potential which can act as the neutral terminal. The processor 22 then stores these measurements in internal memory 23 and feeds the measurements back to a central server via a communications unit 24. The smart meter 20 also comprises a switching unit that is capable of disconnecting the load from the grid 10. The smart meter 20 is arranged to disconnect the load in response to instructions received from the central server via the communications unit 24, or if the processor 22 determines that characteristics of the power supply could result in damage to the load. The smart meter 20 is therefore also arranged to monitor characteristics of the electricity supply. The method by which the processor 22 monitors the electricity supply and determines whether the electricity supply could cause damage to load is set-out below with reference to Figure 3.

Figure 3 provides a schematic illustration of an algorithm for estimating the fundamental frequency of an electrical signal at the smart meter. The algorithm is stored within the memory 23 of the smart meter 20 and implemented in the processor 22 of the smart meter 20. While the description of the algorithm provided herein is for use in a smart meter, it will be appreciated that the algorithm could be utilized for frequency estimation at any node within an electricity grid, such as at a substation.

The algorithm utilizes a closed phase-locked loop (PLL), 100, and the algorithm comprises a number of processing blocks. Each of the processing blocks shall now be described in turn.

The input to the system is a three-phase electrical input. In particular, the input derives from a measurement at the node of a three-phase voltage. It will be appreciated that in alternative embodiments of the invention a three-phase current measurement is provided as the input. However, a voltage input is preferable because a voltage input has a lower harmonic distortion (THD) than a current input.

Block 101 includes a Concordia transform, the operation of which shall now be described. Three-phase voltages are received with voltage signals $V_a$, $V_b$, $V_c$. These three-phase voltages can be represented in terms of the rms voltage and the phase or the angular frequency, as shown by Equation 1:

$$\begin{bmatrix} V_a \\ V_b \\ V_c \end{bmatrix} = \sqrt{2}V_{eff} \begin{bmatrix} \sin(\theta) \\ \sin(\theta - \dfrac{2\pi}{3}) \\ \sin(\theta + \dfrac{2\pi}{3}) \end{bmatrix} = \sqrt{2}V_{eff} \begin{bmatrix} \sin(\omega t) \\ \sin(\omega t - \dfrac{2\pi}{3}) \\ \sin(\omega t + \dfrac{2\pi}{3}) \end{bmatrix}$$

*Equation 1*

Wherein $V_{eff}$ is the rms voltage of the signals, $\theta$ is the phase of the signals $\omega$ is the angular frequency of the fundamental frequency where $\omega = 2\pi F$.

The Concordia transformation then transforms the three input parameters into two output parameters $V_\alpha$ and $V_\beta$ as depicted by the matrix shown by equation 2:

$$\begin{bmatrix} V_\alpha \\ V_\beta \end{bmatrix} = \sqrt{\frac{2}{3}} \begin{bmatrix} 1 & -\dfrac{1}{2} & -\dfrac{1}{2} \\ 0 & \dfrac{\sqrt{3}}{2} & -\dfrac{\sqrt{3}}{2} \end{bmatrix} \begin{bmatrix} V_a \\ V_b \\ V_c \end{bmatrix}$$

*Equation 2*

By substituting, in Equation 2, the expressions of the three signals of Equation 1, the expression of $V_\alpha$ and $V_\beta$ can be provided as shown by Equation 3:

$$\begin{bmatrix} V_\alpha \\ V_\beta \end{bmatrix} = \begin{bmatrix} \sqrt{3} V_{eff} \sin(\theta) \\ -\sqrt{3} V_{eff} \cos(\theta) \end{bmatrix}$$

$$\textit{Equation 3}$$

The general formulation of a three-phase voltage system includes a direct rotating component, an inverse rotating component, and a homopolar component. The Concordia transformation eliminates the influence of the homopolar component and treats the direct and inverse rotating components of the signal identically. The expressions of $V_\alpha$ and $V_\beta$ are therefore a linear sum of the direct and inverse components. The two-phase transformed components can be considered a two-phase orthogonal time varying coordinate representation of the three-phase components of the signal.

In alternative embodiments of the invention the smart meter may be connected to a single-phase electricity supply. If a single-phase input is received, Second Order Generalized Integrator (SOGI) system is utilized to transform the single phase voltage or current to the orthogonal $V_\alpha$ and $V_\beta$ representation. The transformation of the SOGI system is shown in equation 4:

$$\begin{cases} \dfrac{V_\alpha(s)}{V_i(s)} = \dfrac{K\omega s}{s^2 + K\omega s + \omega^2} \\ \dfrac{V_\beta(s)}{V_i(s)} = \dfrac{K\omega^2}{s^2 + K\omega s + \omega^2} \end{cases}$$

$$\textit{Equation 4}$$

Wherein $V_i(s)$ is the input voltage, $V_\alpha(s)$ and $V_\beta(s)$ are the output voltages, K is the gain, $\omega$ is the angular frequency, and $s$ is the Laplace parameter.

The output of block 101 is then received by the band pass filter block 102, wherein a band pass filter is applied to the $V_\alpha$ and $V_\beta$ components. This filtering process helps to provide robustness against disturbances of signals network waveforms.

The multi-variable filter 102 is a band pass filter with a selective adjustment parameter k which allows the filter to compromise between sensitivity (e.g. noise influence) and dynamic performance (e.g. time response). The selective adjustment parameter k is a parameter indicative of the estimated fundamental frequency, which is fed back from the previous frequency estimation at the output of the overall system.

The filter is arranged so that for the reference frequency:

- Unity gain is provided, H (s) = 0 dB, to guarantee the conservation of the amplitude of the input signals to the output; and
- the phase of the reference frequency is not altered by ensuring that there is a zero phase shift, which thereby avoids phase perturbation of what is estimated to be the fundamental frequency.

In other words, the filter is arranged to maintain the fundamental frequency in its proper form and filter out noise, which may affect the quality and accuracy of the frequency estimation. The frequency feedback inside the regulation loop guarantees the tuning of the multi variable filter at each sampling period. Consequently, at the sampling instant $t_n$, the multivariable filter is tuned by the frequency estimated at time $t_{n-1}$.

This expression of the transfer function of the multi variable band pass filter is obtained in a fix reference $V_\alpha$ and $V_\beta$:

$$\begin{cases} V_{\alpha\_f}(s) = \dfrac{k}{s}[V_\alpha(s) - V_{\alpha\_f}(s)] - \dfrac{\omega_c}{s} V_{\beta\_f}(s) \\ V_{\beta\_f}(s) = \dfrac{k}{s}[V_\beta(s) - V_{\beta\_f}(s)] - \dfrac{\omega_c}{s} V_{\alpha\_f}(s) \end{cases}$$

$$\textit{Equation 5}$$

Wherein $V_\alpha$ and $V_\beta$ are coordinates in a stationary reference frame; $V_{\alpha\_f}$ and $V_{\beta\_f}$ are coordinates in a stationary reference frame at multi variable band pass filter output, $\omega_c$ represents the central pulsation, and the parameter k sets the filter selectivity.

After being filtered, the components $V_\alpha$ and $V_\beta$ are then transformed again using the Park transformation block 103. The Park transformation utilizes the matrix shown in equation 6:

$$\begin{bmatrix} V_d \\ V_q \end{bmatrix} = \begin{bmatrix} \cos(\hat{\theta}) & \sin(\hat{\theta}) \\ -\sin(\hat{\theta}) & \cos(\hat{\theta}) \end{bmatrix} \begin{bmatrix} V_\alpha \\ V_\beta \end{bmatrix}$$

*Equation 6*

Wherein $\hat{\theta}$ is an estimated phase angle, $V_d$ and $V_q$ are components of synchronous reference, i.e. the angular rotating speed that is the same as the angular speed of the input signal. The definitions of $V_\alpha$ and $V_\beta$ depicted in Equation 3 can then be inserted into Equation 6 to provide the following definition of $V_d$ and $V_q$:

$$\begin{bmatrix} V_d \\ V_q \end{bmatrix} = \sqrt{3}V_{eff} \begin{bmatrix} \sin(\theta - \hat{\theta}) \\ -\cos(\theta - \hat{\theta}) \end{bmatrix}$$

*Equation 7*

Wherein $V_{eff}$ is the RMS voltage value of the signal, $\theta$ is a real phase angle, $\hat{\theta}$ is an estimated phase angle, $V_d$ and $V_q$ are components of synchronous reference.

The estimated phase angle used in Equation 7 is fed back from the output of the voltage controlled oscillator 107 via block 104, which provides sine and cosine expressions of the estimated angle.

The estimated phase angle $\hat{\theta}$ should be very close to the real phase angle. Consequently, the component $V_d$ converges to 0. Hence, as shown by block 105, $V_d$ is assumed to be zero in order to provide an output of $V_d$ alone. On this basis, Equation 7 can be rewritten as:

$$V_d = \sqrt{3}V_{eff}(\theta - \hat{\theta})$$

*Equation 8*

Where $V_{eff}$ is the RMS voltage value of the signal, $\theta$ is a real phase angle, $\hat{\theta}$ is an estimated phase angle

The output of block 105, $\varepsilon$, where $\varepsilon = V_{dsetpoint} - V_d$ is received by the loop filter block 106. The loop filter (LF) is a proportional and integral (PI) controller. The input of the loop filter is the error ($\varepsilon$) and the output of the loop filter is the estimated angular frequency, $\hat{\omega}$. The parameters of the PI controller are determined through an analysis of the transfer function of the global closed loop. As will be seen below, the general formula of the loop filter is a second order filter.

The successive use of the two transforms, Concordia and then Park, along with the loop filter provides a simple and computationally cheap means for extracting the angular frequency from a signal. Furthermore, if the same filtering were applied to the signals $V_a$, $V_b$, $V_c$ three filters would be required to achieve the same functionality. Hence, the implementation of this filter by use of V$\alpha$ and V$\beta$ simplifies the filter implementation.

The loop filter $F_B(s)$ associated with the PLL can be reduced to a PI filter. The associated transfer function is shown by Equation 9:

$$F_B(s) = k_p + \frac{k_i}{s} = k_p \left( \frac{1 + \tau_i s}{\tau_i s} \right)$$

*Equation 9*

Wherein $k_p$ is a proportional function, $k_i$ is the Integral gain, $\tau_i$ is a time constant, and s is the Laplace parameter.

The estimated angular frequency $\hat{\omega}$ is the derivative of the instantaneous estimation of the phase angle $\hat{\theta}$ as shown by Equation 10:

$$\widehat{\omega} = \frac{d\widehat{\theta}}{dt}$$

*Equation 10*

The estimated angular frequency can also be expressed as a function of the loop filter $F_B(s)$ and of the $V_d$ component, as shown by Equation 11:

$$\widehat{\omega} = F_B(s) * V_d = k_p \left(\frac{1 + \tau_i s}{\tau_i s}\right) * \sqrt{3} V_{eff} \left(\theta - \widehat{\theta}\right)$$

*Equation 11*

Wherein the loop filter can be defined by developing the closed loop expression of the function $F_{BF}(s)$ of $\frac{\widehat{\theta}(s)}{\theta(s)}$ : as shown in Equation 12:

$$F_{BF} = \frac{\widehat{\theta}(s)}{\theta(s)} = \frac{k_p \left(\frac{1 + \tau_i s}{\tau_i s}\right) * \sqrt{3} V_{eff} * \frac{1}{s}}{1 + k_p \left(\frac{1 + \tau_i s}{\tau_i s}\right) * \sqrt{3} V_{eff} * \frac{1}{s}}$$

*Equation 12*

A second order transfer function can then be determined, which is written in the form shown in Equation 13:

$$\frac{\widehat{\theta}(s)}{\theta(s)} = \frac{2\xi\omega_n s + \omega_n^2}{s^2 + 2\xi\omega_n s + \omega_n^2}$$

*Equation 13*

Wherein $\omega_n$ is the angular frequency, $\xi$ is the damping term, $\widehat{\theta}$ is an estimated phase angle, $\theta(s)$ is a real phase angle.

The parameters $k_p$ and $\tau_i$ of the loop filter $F_B(s)$ depend on terms $\xi$ and $\omega_n$ as defined by Equations 14 and 15:

$$k_p = \frac{2\xi\omega_n}{\sqrt{3} V_{eff}}$$

*Equation 14*

$$\tau_i = \frac{2\xi}{\omega_n}$$

*Equation 15*

The estimated angular frequency which has been determined from the loop filter stage is then integrated by a Voltage Controlled Oscillator at block 107, as discussed below.

The Voltage Controlled Oscillator 107 is effectively an integrator that converts the angular frequency into a corresponding phase angle:

$$\theta = \omega.t \; et \; d\theta = \omega.dt \; so \; \frac{d\theta}{dt} = \omega \; wherin \; s.\theta = \omega$$

*Equation 16*

The result of this integration is an estimated phase angle, as shown by Equation 16:

$$\hat{\theta} = \frac{1}{s}\hat{\omega}$$

*Equation 17*

Consequently, the output of block 107 is the estimated phase angle which is fed back for the Park Transformation at block 103, via block 104. The estimated phase angle is also utilised in block 108 to estimate the frequency of the electrical signal in accordance with equation 18:

$$\hat{F}(k) = \frac{\Delta\hat{\theta}}{2\pi T_e}$$

*Equation 18*

The regulation loop is a discreet process $\Delta\theta = \theta(k+1)-\theta(k) = Te2\pi F(k)$. In this loop the angle $\theta$ is a continuously increasing ramp; the difference between two successive values of this ramp is divided by the sampling period (Te) and by $2\pi$.

The frequency estimated at block 108 is the estimated frequency fed back to the multi variable band pass filter at block 102.

Using the estimated frequency, the rate of change of the fundamental frequency is then determined for each period of the fundamental frequency. The determination of the rate of change of frequency is carried out at block 109.

The regulation loop described above comprising blocks 101 through to 108 delivers a permanent flow of the estimated fundamental frequency, $f(n)$, $f(n+1)$, $f(n+2)$, at the sampling period of the system. This data is then input into block 109, which then filters the instantaneous data, calculates the average value of the fundamental frequency per cycle and thereby estimates the rate of change of the frequency per cycle. The ratio between the nominal fundamental frequency and the sampling rate determines the number of samples per period: NT. This process is discussed in more detail below.

Firstly, the fundamental frequency is filtered and averaged for each cycle. The nominal number of samples per cycle is NT, abnormal delta positive or negative (for example, +/-2milliHertz) between two successive estimated values of the fundamental frequencies causes the elimination of the frequency values.

The fundamental frequency is obtained at every sampling period. Since the system cannot have a very fast variation of the frequency between two samples (sampling period being $250\mu s$ to $500\ \mu s$) there is a high difference between successive values of the fundamental frequency. This is a sign of an error in the estimation (this difference can be taken: +/-2milliHertz), and the consequence is that this value is not taken into account.

These estimated values are not taken into account in the next calculations because they are erroneous. Over a cycle, only NT - x values of the fundamental frequency therefore remain, where x is the number of values eliminated on the criteria of abnormal difference between two estimated values. Hence, the average fundamental frequency value ($f_{av}$) is calculated over the cycle with the NT-x remaining values.

The rate of change of frequency per period is estimated by the least squares method giving the average slope $\frac{df(t)}{dt}$ among the (Nt-x) validated sampled values of the fundamental frequency as shown by Equation 19:

$$\frac{df(t)}{dt} = \frac{\sum Ti.Fi}{\sum Ti^2}$$

*Equation 19*

Wherien $T_i = t_i - t_{av}$ and $F_i = f_i - f_{av}$, where $t_i$ = time of the sample i (i from 1 to NT - x), $t_{av}$ is the average value of all the $t_i$, $f_i$ is the estimated frequency at sample i (i from 1 to NT - x), and $f_{av}$ is the average value of the fundamental frequency over the cycle

Once the frequency and rate of change of frequency are obtained, these values can then be displayed as graphical representations. The graphical representations could then be used by the electricity supply board or direct user. The display processing is performed by block 110. Block 110 could alternatively be performed at a central server based on data received from the smart meter.

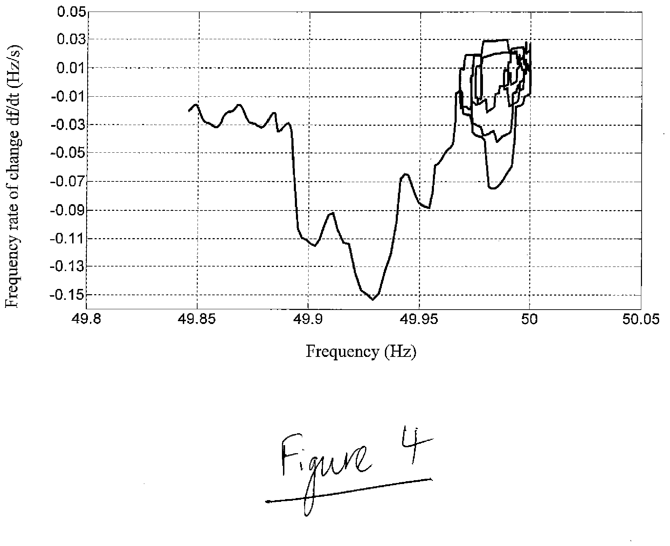

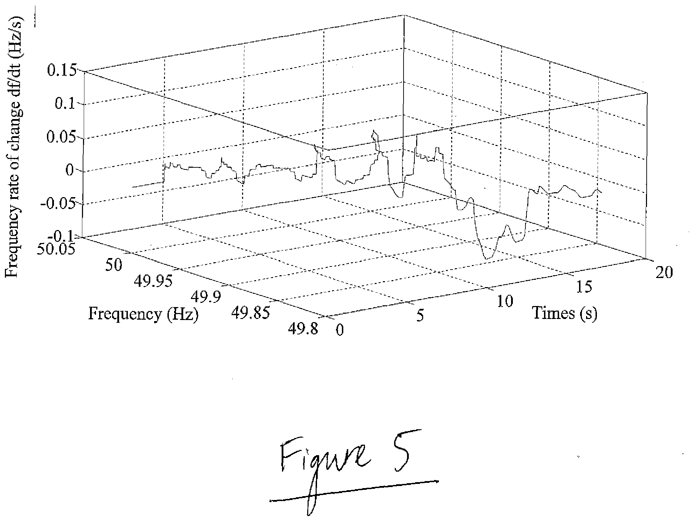

The graphical representations provided by Block 110 include representations of variations in the average fundamental frequency per cycle and the rate of change of the average fundamental frequency per cycle. Such data can be represented in a two dimensional graphic, as shown by Figure 4, which shows the rate of change of frequency, $\frac{df(t)}{dt}$, as a function of frequency, $f(t)$, for the excursion of the fundamental frequency for the well-known major European grid disturbance on 4 November 2006 which resulted in a large black-out. Figure 4 specifically shows the pre-black-out conditions. In addition or alternatively, a three-dimensional graphical representation can be provided as shown in Figure 5, which illustrates the rate of change of frequency, $\frac{df(t)}{dt}$, as a function of frequency, $f(t)$, and time, t, for the disturbance on 4 November 2006.

It is also possible, within these graphical representations, to define an alarm boundary at which point it is determined that the fundamental frequency is varying in a dangerous manner. If an alarm boundary is passed then at least part of the grid is shut down to prevent damage to electrical devices connected to the grid system. The alarm boundary can be represented as a maximum limit for the frequency and rate of change of frequency. The alarm therefore acts as a frequency protection relay making disconnection of critical loads of the electrical grid directly by the electricity meter switch possible.

It is also possible to provide a graphical representation of the maximum values of the fundamental frequency and the rate of change of the fundamental frequency per hour or per day. This is known as a time stamped historic record of the maximum values of the fundamental frequency and rate of change of the fundamental frequency.

An example of the implementation of the above-described system shall now be provided.

Experimentation to validate the behavior of the algorithm on a single-phase and a poly-phase network has been done. The experimentation has benchmarked the frequency profile of the UCTE Report of the blackout failure of 4 November 2006.

The signal was reconstituted at $200\mu s$ sampling period over a total interval of 20 seconds. This was therefore a file of 100,000 points per phase and 1,000 cycles. The ratio between the sampling period and the fundamental period is 1/100.

The profile of the fundamental frequency is the reference, the input signals have been intentionally disturbed by unbalanced components for the three phase systems and harmonics.

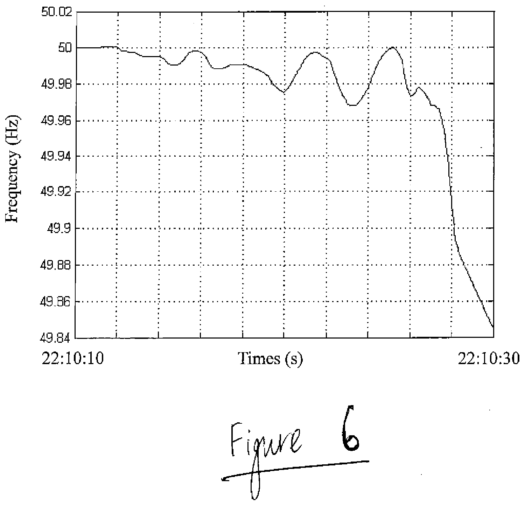

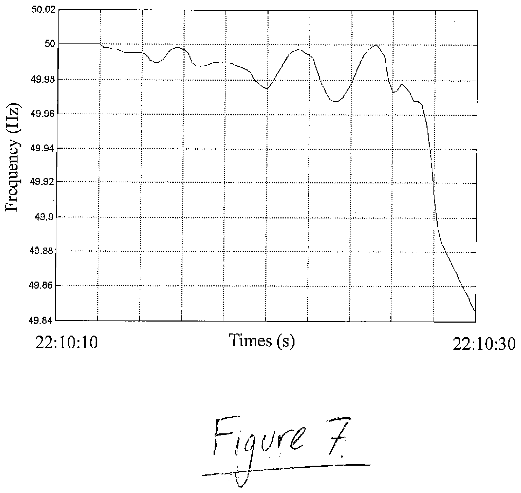

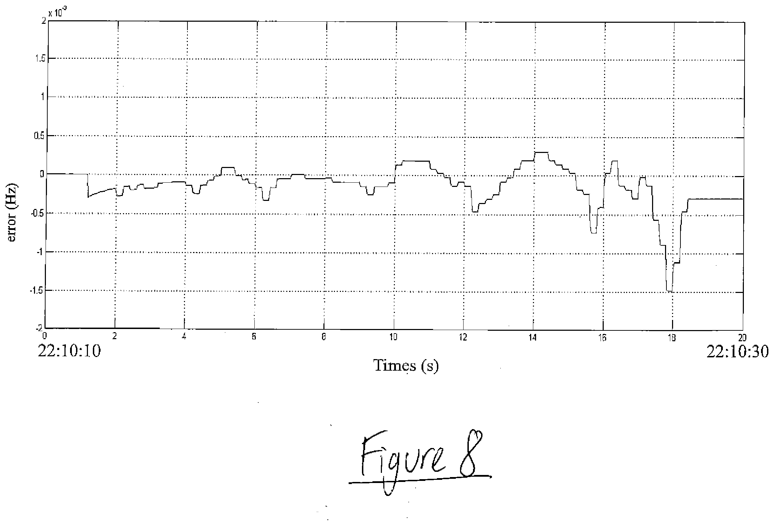

Figure 6 illustrates computed with the algorithm presented above, while Figure 7 illustrates the network frequency measured in the field. The error between the field measurement and estimated frequency is shown by Figure 8. It can therefore be seen that the difference between the field measurement and the estimated frequency is lower than +/-1millihertz.

For these calculations, a sampling rate of 5kHz (Te = $200\mu s$) was used, the number of samples per period was around 100, among these NT (100) samples all of the abnormal and therefore erroneous samples were removed between two successive values lower or higher to established limits were eliminated, and then on the remaining samples the average frequency value ($f_{av}$) were calculated. The average frequency value, $f_{av}$ is the average value of the fundamental frequency calculated on the remaining Nt - x values over a cycle. This value can be stored as the average value of the fundamental frequency over the cycle.

Per period, the rate of change of frequency was estimated by the least squares method giving the average slope $\frac{df(t)}{dt}$ among these 100 samples. Considering the high accuracy of the frequency estimation (+/-1millihertz) a reliable estimation of the derivative of the fundamental frequency was obtained per fundamental cycle (better than 0,1Hz per second).

When implemented by a processor on a smart-meter or as a computer program on any type of computer, a computer would be provided having a memory to store the computer program, and a processor to implement the computer program. The processor would then perform the algorithmic process. The computer program may include computer code arranged to instruct a computer to perform the functions of one or more of the various methods described above. The computer program and/or the code for performing such methods may be provided to an apparatus, such as a computer, on a computer readable medium. The computer readable medium could be, for example, an electronic, magnetic, optical, electromagnetic, infrared, or semiconductor system, or a propagation medium for data transmission, for example for downloading the code over the Internet. Non-limiting examples of a physical computer readable medium include semiconductor or solid state memory, magnetic tape, a removable computer diskette, a random access memory (RAM), a read-only memory (ROM), a rigid magnetic disc, and an optical disk, such as a CD-ROM, CD-R/W or DVD.

**Claims**

1. A method for estimating a frequency of an electrical signal, the method comprising:

converting (101) a first signal having three components into a second signal having two components in accordance with a first transformation, wherein each component of the first signal corresponds to a phase component of a three-phase electrical signal and the two components of the second signal are representative of characteristics of the three-phase electrical signal;
filtering (102) the second signal in accordance with a previous frequency estimation;
converting (103) the filtered second signal into a third signal having a single component in accordance with a second transformation, wherein the single component of the third signal is representative of characteristics of the three-phase electrical signal; and
estimating (105-109) a frequency of the third signal, wherein the estimated frequency of the third signal is indicative of a frequency of the three-phase electrical signal.

2. The method according to claim 1, wherein the filtering comprises applying a band pass filter to the second signal, the band pass filter being centred on the frequency of a previous frequency estimation.

3. The method according to claim 2, wherein the band pass filter is arranged to apply unity gain and zero phase shift at the frequency of the previous frequency estimation.

4. The method according to any one of claims 1 to 3, further comprising feeding back the current frequency estimation for filtering the next frequency estimation.

5. The method according to any preceding claim, wherein the first transformation is a Concordia transformation, as defined by:

$$\begin{bmatrix} V_\alpha \\ V_\beta \end{bmatrix} = \sqrt{\frac{2}{3}} \begin{bmatrix} 1 & -\dfrac{1}{2} & -\dfrac{1}{2} \\ 0 & \dfrac{\sqrt{3}}{2} & -\dfrac{\sqrt{3}}{2} \end{bmatrix} \begin{bmatrix} V_a \\ V_b \\ V_c \end{bmatrix}$$

wherein $V_a$, $V_b$, $V_c$ are the three components of the first signal and $V_\alpha$ and $V_\beta$ are the two components of the second signal.

6. The method according to any preceding claim, wherein the second transformation utilises a previous estimation of a phase of the three-phase electrical signal.

7. The method according to any preceding claim, wherein the second transformation is a Park transformation, as defined by:

$$\begin{bmatrix} V_d \\ V_q \end{bmatrix} = \begin{bmatrix} \cos(\hat{\theta}) & \sin(\hat{\theta}) \\ -\sin(\hat{\theta}) & \cos(\hat{\theta}) \end{bmatrix} \begin{bmatrix} V_\alpha \\ V_\beta \end{bmatrix}$$

wherein $V_\alpha$ and $V_\beta$ are the two components of the second signal after being filtered, $\hat{\theta}$ is a previous estimation of a phase of the three-phase electrical signal, and $V_d$ and $V_q$ are outputs of the second transformation, wherein $V_d$ is forced to zero and $V_q$ therefore corresponds to the third signal.

8. The method according to any preceding claim, wherein the frequency is estimated by:

estimating a phase of the third signal; and
estimating the frequency of the third signal in accordance with the estimated phase.

9. The method according to claim 8, wherein the phase is estimated using a phase locked loop.

10. The method according to claim 9, wherein the phase locked loop comprises a loop filter arranged to estimate an angular frequency of the signal having a single component and a voltage controlled oscillator arranged to estimate the phase of the estimated angular frequency.

11. The method according to any one or claims 8 to 10, further comprising feeding back the estimated phase to the second transformation for estimating a next phase.

12. The method according to any preceding claim, further comprising calculating the average frequency over a period of time, wherein a plurality of frequency estimations are made during the period of time.

13. The method according to claim 12, further comprising determining an error level in the frequency estimation and excluding any frequency estimations from the average frequency calculation having an error level greater than an error threshold.

14. The method according to claim 12 or 13, further comprising determining a rate of change of frequency from the average frequency.

15. The method according to any preceding claim, further comprising measuring the three components of the three-phase electrical signal.

16. The method according to claim 15, wherein the measurement comprises measuring voltages of the three-phase electrical signal.

17. The method according to any one of claims 1 to 14, further comprising converting a single-phase electrical signal into the three-phase electrical signal in accordance with a third transformation before converting the three-phase signal in accordance with the first transformation.

18. Apparatus for estimating a frequency of an electrical signal, the apparatus arranged to implement the method of any preceding claim.

19. The apparatus according to claim 18, wherein the apparatus is an electricity meter.

20. The apparatus according to claim 19, wherein the electricity meter further comprises:

   a sensor arranged to measure one or more characteristics of an electrical signal;
   a memory arranged to store the one or more characteristics of the electrical signal and store a computer program for implementing the method;
   a processor arranged to perform the method in accordance with the stored characteristics of the electrical signal and the computer program; and
   a communications unit arranged to transmit information relating to the frequency estimation to a central server.

21. A computer readable medium comprising computer readable code operable, in use, to instruct a computer to perform the method of any one of claims 1 to 17.

**Patentansprüche**

1. Verfahren zum Schätzen einer Frequenz eines elektrischen Signals, wobei das Verfahren umfasst:

   Umwandeln (101) eines ersten Signals mit drei Komponenten in ein zweites Signal mit zwei Komponenten gemäß einer ersten Transformation, wobei jede Komponente des ersten Signals einer Phasenkomponente eines dreiphasigen elektrischen Signals entspricht und die zwei Komponenten des zweiten Signals repräsentativ für Eigenschaften des dreiphasigen elektrischen Signals sind;
   Filtern (102) des zweiten Signals gemäß einer vorherigen Frequenzschätzung;
   Umwandeln (103) des gefilterten zweiten Signals in ein drittes Signal mit einer einzigen Komponente gemäß einer zweiten Transformation, wobei die einzige Komponente des dritten Signals repräsentativ für Eigenschaften des dreiphasigen elektrischen Signals ist; und
   Schätzen (105-109) einer Frequenz des dritten Signals, wobei die geschätzte Frequenz des dritten Signals ein Indikator für eine Frequenz des dreiphasigen elektrischen Signals ist.

2. Verfahren nach Anspruch 1, wobei das Filtern Anwenden eines Bandpassfilters auf das zweite Signal umfasst, wobei der Bandpassfilter auf die Frequenz einer vorherigen Frequenzschätzung zentriert ist.

3. Verfahren nach Anspruch 2, wobei der Bandpassfilter angeordnet ist, um eine Einheitsverstärkung und eine Nullphasenverschiebung bei der Frequenz der vorherigen Frequenzschätzung anzuwenden.

4. Verfahren nach einem der Ansprüche 1 bis 3, ferner umfassend das Rückkoppeln der aktuellen Frequenzschätzung zum Filtern der nächsten Frequenzschätzung.

5. Verfahren nach einem der vorhergehenden Ansprüche, wobei die erste Transformation eine Concordia-Transformation ist, wie sie definiert ist durch:

$$\begin{bmatrix} V_\alpha \\ V_\beta \end{bmatrix} = \sqrt{\frac{2}{3}} \begin{bmatrix} 1 & -\frac{1}{2} & -\frac{1}{2} \\ 0 & \frac{\sqrt{3}}{2} & -\frac{\sqrt{3}}{2} \end{bmatrix} \begin{bmatrix} V_a \\ V_b \\ V_c \end{bmatrix}$$

wobei $V_a$, $V_b$, $V_c$ die drei Komponenten des ersten Signals sind und $V_\alpha$ und $V_\beta$ die zwei Komponenten des zweiten Signals sind.

6. Verfahren nach einem der vorhergehenden Ansprüche, wobei die zweite Transformation eine vorherige Schätzung einer Phase des dreiphasigen elektrischen Signals verwendet.

7. Verfahren nach einem der vorhergehenden Ansprüche, wobei die zweite Transformation eine Park-Transformation ist, wie sie definiert ist durch:

$$\begin{bmatrix} V_d \\ V_q \end{bmatrix} = \begin{bmatrix} \cos(\hat{\theta}) & \sin(\hat{\theta}) \\ -\sin(\hat{\theta}) & \cos(\hat{\theta}) \end{bmatrix} \begin{bmatrix} V_\alpha \\ V_\beta \end{bmatrix}$$

wobei $V_\alpha$ und $V_\beta$ die zwei Komponenten des zweiten Signals nach dem Filtern sind, $\hat{\theta}$ eine vorherige Schätzung einer Phase des dreiphasigen elektrischen Signals ist und $V_d$ und $V_q$ Ausgaben der zweiten Transformation sind, wobei $V_d$ auf null gezwungen wird und $V_q$ daher dem dritten Signal entspricht.

8. Verfahren nach einem der vorhergehenden Ansprüche, wobei die Frequenz geschätzt wird durch:

Schätzen einer Phase des dritten Signals; und
Schätzen der Frequenz des dritten Signals gemäß der geschätzten Phase.

9. Verfahren nach Anspruch 8, wobei die Phase unter Verwendung einer Phasenregelschleife geschätzt wird.

10. Verfahren nach Anspruch 9, wobei die Phasenregelschleife einen Schleifenfilter, der angeordnet ist, um eine Winkelfrequenz des Signals mit einer einzigen Komponente zu schätzen, und einen spannungsgesteuerten Oszillator, der angeordnet ist, um die Phase der geschätzten Winkelfrequenz zu schätzen, umfasst.

11. Verfahren nach einem der Ansprüche 8 bis 10, ferner umfassend Rückkoppeln der geschätzten Phase zu der zweiten Transformation zum Schätzen einer nächsten Phase.

12. Verfahren nach einem der vorhergehenden Ansprüche, ferner umfassend Berechnen der Durchschnittsfrequenz über eine Zeitperiode, wobei mehrere Frequenzschätzungen während der Zeitperiode durchgeführt werden.

13. Verfahren nach Anspruch 12, ferner umfassend Bestimmen eines Fehlerpegels in der Frequenzschätzung und Ausschließen jeglicher Frequenzschätzungen von der Durchschnittsfrequenzberechnung, die einen Fehlerpegel aufweisen, der größer als ein Fehlerschwellenwert ist.

14. Verfahren nach Anspruch 12 oder 13, ferner umfassend Bestimmen einer Frequenzänderungsrate aus der Durchschnittsfrequenz.

**15.** Verfahren nach einem der vorhergehenden Ansprüche, ferner umfassend Messen der drei Komponenten des dreiphasigen elektrischen Signals.

**16.** Verfahren nach Anspruch 15, wobei das Messen Messen der Spannungen des dreiphasigen elektrischen Signals umfasst.

**17.** Verfahren nach einem der Ansprüche 1 bis 14, ferner umfassend Umwandeln eines einphasigen elektrischen Signals in das dreiphasige elektrische Signal gemäß einer dritten Transformation vor dem Umwandeln des dreiphasigen Signals gemäß der ersten Transformation.

**18.** Vorrichtung zum Schätzen einer Frequenz eines elektrischen Signals, wobei die Vorrichtung dafür angeordnet ist, das Verfahren nach einem der vorhergehenden Ansprüche auszuführen.

**19.** Vorrichtung nach Anspruch 18, wobei die Vorrichtung ein Elektrizitätszähler ist.

**20.** Vorrichtung nach Anspruch 19, wobei der Elektrizitätszähler ferner umfasst:

einen Sensor, der angeordnet ist, um eine oder mehrere Eigenschaften eines elektrischen Signals zu messen;
einen Speicher, der angeordnet ist, um die eine oder die mehreren Eigenschaften des elektrischen Signals zu speichern und ein Computerprogramm zum Ausführen des Verfahrens zu speichern;
einen Prozessor, der angeordnet ist, um das Verfahren gemäß den gespeicherten Eigenschaften des elektrischen Signals und dem Computerprogramm durchzuführen; und
eine Kommunikationseinheit, die angeordnet ist, um Informationen betreffend die Frequenzschätzung zu einem zentralen Server zu übertragen.

**21.** Computerlesbares Medium, das einen computerlesbaren Code umfasst, der betreibbar ist, um im Betrieb einen Computer anzuweisen, das Verfahren nach einem der Ansprüche 1 bis 17 durchzuführen.

## Revendications

**1.** Procédé d'estimation d'une fréquence d'un signal électrique, le procédé comprenant :

la conversion (101) d'un premier signal ayant trois composantes en un deuxième signal ayant deux composantes en fonction d'une première transformation, chaque composante du premier signal correspondant à une composante de phase d'un signal électrique triphasé et les deux composantes du deuxième signal étant représentatives des caractéristiques du signal électrique triphasé ;
le filtrage (102) du deuxième signal en fonction d'une estimation de fréquence précédente ;
la conversion (103) du deuxième signal filtré en un troisième signal ayant une composante unique en fonction d'une seconde transformation, la composante unique du troisième signal étant représentative des caractéristiques du signal électrique triphasé ; et
l'estimation (105-109) d'une fréquence du troisième signal, la fréquence estimée du troisième signal étant indicative d'une fréquence du signal électrique triphasé.

**2.** Procédé selon la revendication 1, le filtrage comprenant l'application d'un filtre passe-bande au deuxième signal, le filtre passe-bande étant centré sur la fréquence d'une estimation de fréquence précédente.

**3.** Procédé selon la revendication 2, le filtre passe-bande étant agencé pour appliquer un gain unitaire et un décalage de phase nul à la fréquence de l'estimation de fréquence précédente.

**4.** Procédé selon l'une quelconque des revendications 1 à 3, comprenant en outre l'étape consistant à renvoyer l'estimation de fréquence actuelle pour filtrer l'estimation de fréquence suivante.

**5.** Procédé selon l'une quelconque des revendications précédentes, la première transformation étant une transformation de Concordia, telle que définie par :

$$\begin{bmatrix} V_\alpha \\ V_\beta \end{bmatrix} = \sqrt{\frac{2}{3}} \begin{bmatrix} 1 & -\frac{1}{2} & -\frac{1}{2} \\ 0 & \frac{\sqrt{3}}{2} & -\frac{\sqrt{3}}{2} \end{bmatrix} \begin{bmatrix} V_a \\ V_b \\ V_c \end{bmatrix}$$

$V_a$, $V_b$ et $V_c$ étant les trois composantes du premier signal et $V_\alpha$ et $V_\beta$ étant les deux composantes du deuxième signal.

6. Procédé selon l'une quelconque des revendications précédentes, la seconde transformation utilisant une estimation précédente d'une phase du signal électrique triphasé.

7. Procédé selon l'une quelconque des revendications précédentes, dans lequel la seconde transformation est une transformation de Park, telle que définie par :

$$\begin{bmatrix} V_d \\ V_q \end{bmatrix} = \begin{bmatrix} \cos(\hat{\theta}) & \sin(\hat{\theta}) \\ -\sin(\hat{\theta}) & \cos(\hat{\theta}) \end{bmatrix} \begin{bmatrix} V_\alpha \\ V_\beta \end{bmatrix}$$

$V_\alpha$ et $V_\beta$ étant les deux composantes du deuxième signal après avoir été filtrées,
$\hat{\theta}$ est une estimation précédente d'une phase du signal électrique triphasé, et $V_d$ et $V_q$ étant des sorties de la seconde transformation, $V_d$ étant forcée à zéro et $V_q$ correspondant donc au troisième signal.

8. Procédé selon l'une quelconque des revendications précédentes, la fréquence étant estimée par :

estimation d'une phase du troisième signal ; et
estimation de la fréquence du troisième signal en fonction de la phase estimée.

9. Procédé selon la revendication 8, la phase étant estimée à l'aide d'une boucle à verrouillage de phase.

10. Procédé selon la revendication 9, la boucle à verrouillage de phase comprenant un filtre à boucle, agencé pour estimer une fréquence angulaire du signal ayant une composante unique, et un oscillateur commandé en tension, agencé pour estimer la phase de la fréquence angulaire estimée.

11. Procédé selon l'une quelconque des revendications 8 à 10, comprenant en outre l'étape consistant à renvoyer la phase estimée à la seconde transformation pour estimer une phase suivante.

12. Procédé selon l'une quelconque des revendications précédentes, comprenant en outre le calcul de la fréquence moyenne sur une période de temps, une pluralité d'estimations de fréquence étant effectuées pendant la période de temps.

13. Procédé selon la revendication 12 comprenant en outre la détermination d'un niveau d'erreur dans l'estimation de fréquence et excluant toute estimation de fréquence à partir du calcul de fréquence moyenne ayant un niveau d'erreur supérieur à un seuil d'erreur.

14. Procédé selon la revendication 12 ou 13, comprenant en outre la détermination d'un taux de variation de fréquence à partir de la fréquence moyenne.

15. Procédé selon l'une quelconque des revendications précédentes, comprenant en outre la mesure des trois composantes du signal électrique triphasé.

16. Procédé selon la revendication 15, la mesure comprenant la mesure des tensions du signal électrique triphasé.

17. Procédé selon l'une quelconque des revendications 1 à 14, comprenant en outre la conversion d'un signal électrique monophasé en un signal électrique triphasé en fonction d'une troisième transformation avant de convertir le signal triphasé en fonction de la première transformation.

**18.** Appareil pour estimer une fréquence d'un signal électrique, l'appareil étant agencé pour mettre en oeuvre le procédé selon l'une quelconque des revendications précédentes.

**19.** Appareil selon la revendication 18, l'appareil étant un compteur d'électricité.

**20.** Appareil selon la revendication 19, le compteur d'électricité comprenant en outre :

un capteur agencé pour mesurer une ou plusieurs caractéristiques d'un signal électrique ;
une mémoire agencée pour stocker la ou les caractéristiques du signal électrique et stocker un programme informatique pour mettre en oeuvre le procédé ;
un processeur agencé pour mettre en oeuvre le procédé en fonction des caractéristiques stockées du signal électrique et du programme informatique ; et
une unité de communication agencée pour transmettre des informations relatives à l'estimation de fréquence à un serveur central.

**21.** Support lisible par ordinateur comprenant un code lisible par ordinateur utilisable, en utilisation, pour ordonner à un ordinateur de mettre en oeuvre le procédé selon l'une quelconque des revendications 1 à 17.

Figure 1

EP 2 741 092 B1

Figure 2

EP 2 741 092 B1

Figure 3

Figure 4

Figure 5

Figure 6

Figure 7.

Figure 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005207190 A

**Non-patent literature cited in the description**

- **YANG HAN et al.** A novel synchronization scheme for grid-connected converters by using adaptive linear optimal filter based PLL (ALOF-PLL). *Simulation Modelling Practice and Theory,* 2009, vol. 17, 1299-1345